# FASCICULE DE BREVET EUROPEEN

(11) **EP 4 138 128 B1**
(45) Date de publication et mention de la délivrance du brevet: **20.12.2023**
(21) Numéro de dépôt: 22189384.5
(22) Date de dépôt: 09.08.2022
(51) Int. Cl.: H01L 25/16, H10K 59/65

(54) **DISPOSITIF DE CAPTURE D'IMAGES**
BILDERFASSUNGSVORRICHTUNG
IMAGE CAPTURING DEVICE

(30) Priorité: 19.08.2021 FR 2108774
(43) Date de publication de la demande: 22.02.2023
(73) Titulaire: Commissariat à l'énergie atomique et aux énergies alternatives, 75015 Paris (FR)
(72) Inventeur: Templier, François, 38054 Grenoble Cedex 09 (FR); Segura Puchades, Josep, 38054 Grenoble Cedex 09 (FR); Casset, Fabrice, 38054 Grenoble Cedex 09 (FR)
(74) Mandataire: Cabinet Beaumont

(56) Documents cités:
- WO-A1-2020/199674
- US-A1- 2020 035 151

## Description

### Domaine technique

La présente description concerne de façon générale le domaine des dispositifs de capture d'images, et vise plus particulièrement un dispositif de capture d'images dit mixte, combinant une fonction de capture optique et une fonction d'émission lumineuse, et un procédé de fabrication d'un tel dispositif. Plus généralement, elle concerne un dispositif de capture d'images mixte combinant une fonction de capture optique et une autre fonction, par exemple une fonction d'émission ou d'actuation ou une autre fonction de capture.

### Technique antérieure

Il a déjà été proposé, par exemple dans les demandes de brevet WO2017089676, EP3401958 et WO2018185433 précédemment déposées par le demandeur, des dispositifs d'affichage d'images comportant une pluralité de puces électroniques monolithiques élémentaires disposées en matrice sur un même substrat de report. Les puces élémentaires sont montées solidaires du substrat de report et connectées à des éléments de connexion électrique du substrat de report pour leur commande. Chaque puce comporte une ou plusieurs diodes électroluminescentes (LED) et un circuit de commande de ladite une ou plusieurs LED et correspond à un pixel du dispositif. Le circuit de commande comprend une face de connexion opposée à ladite une ou plusieurs LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Ce type de dispositif d'affichage est particulièrement adapté pour réaliser des écrans d'affichage de grande surface, par exemple des écrans d'ordinateur, de téléviseur, de tablette, etc.

On s'intéresse ici plus particulièrement à la réalisation d'un dispositif d'affichage d'images interactif, combinant une fonction d'émission lumineuse et une fonction de capture optique. Plus généralement, on s'intéresse ici à la réalisation d'un dispositif de capture d'images mixte, combinant une fonction de capture optique et une autre fonction, par exemple une fonction d'émission lumineuse ou d'actuation, ou une autre fonction de capture optique.

US 2020/035151 A1 et WO 2020/199674 A1 divulguent des dispositifs selon l'art antérieur.

### Résumé de l'invention

Un mode de réalisation prévoit un dispositif comportant :
- un substrat de report comportant des éléments de connexion électrique ; et
- une pluralité de puces élémentaires fixées et connectées électriquement au substrat de report, chaque puce élémentaire comportant au moins un photodétecteur et un circuit électronique de lecture dudit au moins un photodétecteur,
le dispositif comportant en outre, associé à au moins une puce élémentaire, un élément d'émission, de capture ou d'actuation externe à la puce élémentaire, fixé et connecté électriquement au substrat de report, chaque puce élémentaire comportant un circuit électronique de contrôle de l'élément d'émission, de capture ou d'actuation associé à la puce.

Selon un mode de réalisation, dans chaque puce élémentaire, le circuit électronique de lecture dudit au moins un photodétecteur et le circuit électronique de contrôle de l'élément d'émission, de capture ou d'actuation associé à la puce comprennent des transistors MOS formés dans et sur une couche de silicium monocristallin.

Selon un mode de réalisation, dans chaque puce élémentaire, ledit au moins un photodétecteur est un photodétecteur inorganique à base d'un matériau semiconducteur III-V.

Selon un mode de réalisation, dans chaque puce élémentaire, ledit au moins un photodétecteur comprend une couche d'absorption en arséniure d'indium gallium.

Selon un mode de réalisation, l'élément d'émission, de capture ou d'actuation comprend au moins une diode électroluminescente.

Selon un mode de réalisation, ladite au moins une diode électroluminescente est une diode électroluminescente organique.

Selon un mode de réalisation, chaque élément d'émission, de capture ou d'actuation comprend trois diodes électroluminescentes définissant respectivement trois sous-pixels d'émission, et dans lequel chaque puce élémentaire comprend une pluralité de sous-circuits de commande adaptés à commander individuellement respectivement les trois diodes électroluminescentes.

Selon un mode de réalisation, les trois sous-pixels d'émission sont adaptés à émettre respectivement dans trois gammes de longueurs d'ondes différentes.

Selon un mode de réalisation, dans chaque puce élémentaire, les trois sous-circuits de commande sont reliés à une même borne d'entrée de la puce, connectée à une plage de connexion correspondante du substrat de report, destinée à recevoir séquentiellement des signaux de consigne d'émission des trois diodes électroluminescentes.

Selon un mode de réalisation, l'élément de capture ou d'actuation associé à chaque puce élémentaire est un transducteur piézoélectrique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I et 1J sont des vues en coupe illustrant des étapes successives d'un exemple d'un procédé de fabrication de puces élémentaires de pixel d'un dispositif de capture d'images mixte selon un mode de réalisation ;
la figure 2 est une vue de dessus illustrant de façon schématique et partielle un exemple d'un substrat de report d'un dispositif de capture d'images mixte selon un mode de réalisation ;
les figures 3A, 3B, 3C et 3D sont des vues en coupe illustrant des étapes successives d'un exemple d'un procédé de fabrication d'un dispositif de capture d'images mixte selon un mode de réalisation ;
la figure 4 est un schéma électrique des circuits d'un exemple d'une puce élémentaire de pixel d'un dispositif de capture d'images mixte selon un mode de réalisation ;
la figure 5 est un diagramme illustrant de façon schématique le fonctionnement de la puce élémentaire de pixel de la figure 4 ;
la figure 6 est un schéma électrique des circuits d'un autre exemple d'une puce élémentaire de pixel d'un dispositif de capture d'images mixte selon un mode de réalisation ; et
la figure 7 est un diagramme illustrant de façon schématique le fonctionnement de la puce élémentaire de pixel de la figure 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications que peuvent avoir les dispositifs de capture d'images mixtes décrits n'ont pas été détaillées, les modes de réalisation décrits étant compatibles avec toutes ou la plupart des applications connues d'un dispositif de capture optique intégrant une fonction d'affichage émissif, par exemple des applications de détection de mouvement, de reconnaissance de visage, d'identification, etc., et plus généralement, d'un dispositif de capture optique intégrant une autre fonction, par exemple d'émission, de capture ou d'actuation.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect d'un mode de réalisation, on prévoit un dispositif de capture d'images comportant une pluralité de puces électroniques monolithiques élémentaires disposées en matrice sur un même substrat de report. Comme dans les exemples décrits dans les demandes de brevet WO2017089676, EP3401958 et WO2018185433 précédemment déposées par le demandeur, les puces élémentaires sont montées solidaires du substrat de report et connectées à des éléments de connexion électrique du substrat de report. Chaque puce comporte un ou plusieurs photodétecteurs (par exemple des photodiodes) et un circuit de contrôle dudit un ou plusieurs photodétecteurs et correspond à un pixel du dispositif de capture. Le circuit de contrôle comprend une face de connexion opposée auxdits un ou plusieurs photodétecteurs, comprenant une pluralité de plages (aussi appelées bornes ou plots) de connexion électrique destinées à être connectées au substrat de report pour la commande de la micropuce. Le substrat de report comprend une face de connexion comportant, pour chaque micropuce, une pluralité de plages (aussi appelées bornes ou plots) de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Selon un aspect d'un mode de réalisation, le dispositif de capture d'images mixte comprend en outre une fonction d'émission de lumière, par exemple une fonction d'affichage d'images. Pour cela, le dispositif comprend une pluralité de diodes électroluminescentes (LED), par exemple des LED organiques, agencées en matrice selon des rangées et des colonnes et définissant un dispositif d'affichage d'images. Les LED sont externes aux puces élémentaires de pixel du dispositif de capture mixte, et sont disposées sur le substrat de report du dispositif, du même côté du substrat de report que les puces élémentaires de pixel. Les LED sont connectées à des bornes de connexion électrique du substrat de report pour leur commande. Les LED peuvent émettre dans le visible ou dans l'infrarouges, voire simultanément dans le visible et dans l'infrarouge auquel cas l'une des émissions (de préférence, l'infrarouge) est captée par le dispositif de capture.

A titre d'exemple, le dispositif comprend un groupe élémentaire d'une ou plusieurs LED par puce élémentaire de pixel du dispositif de capture mixte, disposé au voisinage de ladite puce élémentaire de pixel. Autrement dit, la matrice de puces élémentaires de pixel du dispositif de capture et la matrice de groupes élémentaires de LED sont des matrices entrelacées de mêmes dimensions et de même pas.

Selon un aspect d'un mode de réalisation, chaque puce élémentaire de pixel du dispositif de capture mixte intègre un circuit électronique de contrôle du groupe élémentaire d'une ou plusieurs LED correspondant, c'est-à-dire de même position (mêmes coordonnées) dans la matrice de pixels. Chaque puce élémentaire de pixel du dispositif comprend, pour chaque LED du groupe élémentaire d'une ou plusieurs LED correspondant, une borne de connexion connectée individuellement à une électrode de la LED par l'intermédiaire d'une piste conductrice du substrat de report.

Des exemples de réalisation d'un tel dispositif de capture d'images mixte vont être décrits plus en détail ci-après en relation avec les figures.

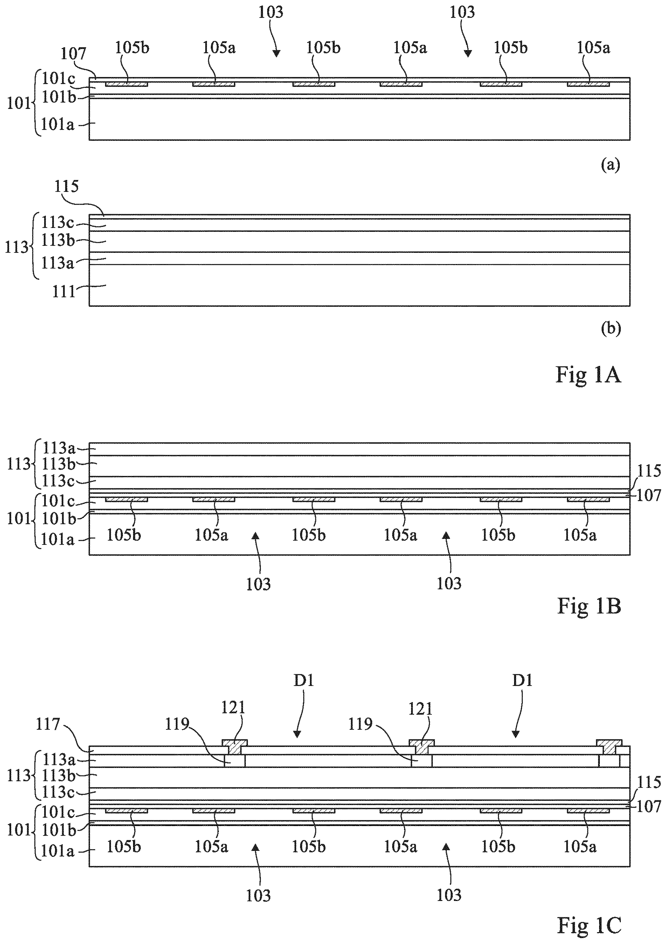

Les figures 1A à 1J sont des vues en coupe illustrant un exemple d'un procédé de fabrication des puces élémentaires de pixel du dispositif.

La figure 1A comprend une vue (a) représentant de façon schématique une structure de commande comprenant un premier substrat 101 dans et sur lequel ont été formés une pluralité de circuits intégrés élémentaires de contrôle 103, par exemple identiques ou similaires, correspondant respectivement aux circuits intégrés de contrôle des futures puces élémentaires de pixel du dispositif.

Dans l'exemple représenté, le substrat 101 est un substrat de type SOI (de l'anglais "Semiconductor On Insulator" - semiconducteur sur isolant), comportant un substrat semiconducteur de support 101a, par exemple en silicium, une couche isolante 101b, par exemple en oxyde de silicium, disposée sur et en contact avec la face supérieure du substrat de support 101a, et une couche semiconductrice supérieure 101c, par exemple en silicium monocristallin, disposée sur et en contact avec la face supérieure de la couche isolante 101b.

Dans cet exemple, les circuits élémentaires de contrôle 103 sont formés dans et sur la couche semiconductrice supérieure 101c du substrat 101. Chaque circuit élémentaire de contrôle 103 comprend par exemple une pluralité de transistors MOS (non détaillés sur les figures 1A à 1J). Les circuits élémentaires de contrôle 103 sont par exemple réalisés en technologie CMOS (de l'anglais "Complementary Métal Oxyde Semiconductor" - métal oxyde semiconducteur complémentaire). Chaque circuit élémentaire de contrôle 103 peut comprendre un circuit de lecture du photodétecteur de la future puce élémentaire de pixel du dispositif, et un circuit adapté à contrôler l'émission de lumière par la ou les LED associées à la future puce élémentaire de pixel du dispositif.

Dans cet exemple, chaque circuit élémentaire de contrôle 103 comprend, du côté de sa face supérieure, un ou plusieurs plots de connexion métalliques 105a, 105b. A titre d'exemple, les plots 105a, 105b affleurent du côté de la face supérieure d'une couche isolante supérieure, par exemple en oxyde de silicium, d'un empilement d'interconnexion (non détaillé sur les figures) revêtant la face supérieure de la couche semiconductrice supérieure 103c du substrat 101. Ainsi, dans cet exemple, la surface supérieure de la structure de contrôle est une surface plane comportant une alternance de régions métalliques (les plots 105a, 105b) et de régions isolantes.

A titre d'exemple, chaque circuit élémentaire de contrôle 103 comprend un plot métallique 105a spécifique pour chaque photodétecteur de la future puce élémentaire de pixel du dispositif, destiné à être connecté à une première borne, par exemple une borne d'anode, du photodétecteur, permettant de lire individuellement un signal électrique représentatif d'un rayonnement lumineux reçu par chaque photodétecteur. Chaque circuit élémentaire de contrôle 103 peut en outre comprendre un plot métallique 105b destiné à être connecté à une deuxième borne, par exemple une borne de cathode de chaque photodétecteur de la future puce élémentaire de pixel du dispositif. Dans le cas où la puce élémentaire comporte plusieurs photodétecteurs, le contact de cathode peut être commun à tous les photodétecteurs de la puce. Ainsi, le circuit élémentaire de contrôle 103 peut comprendre un unique plot métallique 105b. A titre de variante, le circuit élémentaire de contrôle 103 comprend un plot métallique 105b spécifique par photodétecteur.

Dans l'exemple représenté, chaque puce élémentaire de pixel du dispositif comprend un unique photodétecteur, par exemple adapté à capter majoritairement de la lumière infrarouge. Ainsi, chaque circuit élémentaire de contrôle 103 comprend un unique plot métallique 105a et un unique plot métallique 105b destinés à être connectés respectivement aux régions d'anode et de cathode du photodétecteur.

La figure 1A comprend en outre une vue (b) représentant de façon schématique une structure comprenant un deuxième substrat 111, sur la face supérieure duquel repose un empilement actif de diode photosensible 113.

L'empilement 113 est un empilement de couches semiconductrices inorganiques. L'empilement 113 comprend par exemple une ou plusieurs couches en un matériau semiconducteur de type III-V. L'empilement 113 est par exemple un empilement actif de photodiode sensible dans l'infrarouge ou le proche infrarouge. A titre de variante, l'empilement 113 est un empilement actif de photodiode sensible dans le visible. A titre d'exemple, l'empilement 113 comprend, dans l'ordre à partir de la face supérieure du substrat 111, une couche 113a en phosphure d'indium (InP) non intentionnellement dopé, une couche d'absorption 113b en arséniure d'indium-gallium (InGaAs), par exemple intrinsèque ou faiblement dopé de type N (par exemple de l'ordre de 10¹⁵ atomes/cm³), et une couche 113c en phosphure d'indium (InP) dopé de type N. A titre d'exemple, le niveau de dopage de type N de la couche 113c est compris entre 10¹⁶ et 10¹⁸ atomes/cm³. Dans cet exemple, la couche 113b est en contact, par sa face inférieure, avec la face supérieure de la couche 113a, et la couche 113c est en contact, par sa face inférieure, avec la face supérieure de la couche 113b.

Le substrat 111 est par exemple en phosphure d'indium. Les couches 113a, 113b et 113c peuvent être formées successivement par épitaxie sur la face supérieure du substrat 111. Le substrat 111 est alors un substrat de croissance. Une couche tampon, non représentée, par exemple en phosphure d'indium, peut éventuellement faire interface entre le substrat 111 et la couche 113a. La couche tampon est par exemple en contact, par sa face inférieure, avec la face supérieure du substrat 111, et, par sa face supérieure, avec la face inférieure de la couche 113a. La couche tampon peut également être formée par épitaxie à partir de la face supérieure du substrat 111, avant la formation des couches 113a, 113b et 113c.

A titre de variante, plutôt que de former l'empilement actif de diode photosensible 113 par épitaxie sur la face supérieure du substrat 111, l'empilement actif peut être formé dans l'ordre inverse sur un substrat de croissance, non représenté, puis reporté et fixé sur le substrat 111. Dans ce cas, les couches 113c, 113b et 113a sont successivement formées par épitaxie sur une face du substrat de croissance. Une couche tampon, par exemple en phosphure d'indium, peut éventuellement faire interface entre le substrat de croissance et la couche 113c. L'empilement 113 est ensuite fixé sur la face supérieure du substrat 111, par exemple par collage direct ou collage moléculaire de la face inférieure de la couche 113a sur la face supérieure du substrat 111. Le substrat de croissance, et, le cas échéant, la couche tampon faisant interface entre le substrat de croissance et la couche 113c, peuvent ensuite être retirés de façon à libérer l'accès à la face supérieure de la couche 113c. Dans cette variante, le substrat 111 est un substrat de support, par exemple en silicium, ou en tout autre matériau adapté à servir de support de réception de l'empilement actif 113.

A ce stade, chacune des couches de l'empilement actif de diode photosensible 113 s'étend par exemple de façon continue et avec une épaisseur sensiblement uniforme sur toute la surface supérieure du substrat 111.

La figure 1A illustre en outre une étape de dépôt d'une couche diélectrique 107, par exemple en oxyde de silicium, sur et en contact avec la face supérieure de la structure de contrôle de la vue (a). Dans cet exemple, la couche 107 s'étend de façon continue et avec une épaisseur sensiblement uniforme sur toute la surface supérieure de l'empilement d'interconnexion de la structure de contrôle de la vue (a).

La figure 1A illustre de plus une étape de dépôt d'une couche diélectrique 115, par exemple en le même matériau que la couche 107, par exemple en oxyde de silicium, sur et en contact avec la face supérieure de l'empilement actif de diode photosensible 113 de la structure de la vue (b). A titre d'exemple, la couche 115 est déposée sur et en contact avec la face supérieure de la couche 113c. La couche 115 s'étend par exemple de façon continue et avec une épaisseur sensiblement uniforme sur toute la surface supérieure de l'empilement 113.

La figure 1B illustre la structure obtenue à l'issue d'une étape de report et de fixation de l'empilement actif de diode photosensible 113 et de la couche diélectrique 115 sur la structure de contrôle de la vue (a) de la figure 1A.

Sur la figure 1B, l'orientation de la structure de la vue (a) de la figure 1A reste inchangée. En revanche, les éléments de la structure de vue (b) de la figure 1A sont inversés par rapport à l'orientation de la figure 1A.

Lors de cette étape, la structure de la vue (b) de la figure 1A est rapportée sur la face supérieure de la structure de la vue (a) de la figure 1A, en utilisant le substrat 111 comme poignée. La face inférieure (dans l'orientation de la figure 1B, correspondant à la face supérieure dans l'orientation de la figure 1A) de la couche diélectrique 115 est fixée sur la face supérieure de la couche diélectrique 107. La fixation est par exemple obtenue par collage direct ou collage moléculaire de la face inférieure de la couche 115 sur la face supérieure de la couche 107, c'est-à-dire sans apport de matière entre les deux couches.

Le substrat 111 est ensuite retiré, par exemple par meulage et/ou gravure chimique, de façon à libérer l'accès à la face supérieure de l'empilement actif de diode photosensible 113, c'est-à-dire, dans cet exemple, la face supérieure de la couche semiconductrice 113a.

La figure 1C illustre la structure obtenue à l'issue des étapes successives suivantes :
i) dépôt d'une couche diélectrique 117, par exemple en nitrure de silicium ou en oxyde de silicium, sur la face supérieure de la couche 113a, par exemple en contact avec la face supérieure de la couche 113a ;
ii) formation d'ouvertures traversantes localisées dans la couche diélectrique 117, en vis-à-vis de futures zones de reprise de contact de type P correspondant à des régions d'anode des diodes photosensibles du dispositif ;
iii) dopage de type P de régions localisées 119 de la couche 113a, situées en vis-à-vis desdites ouvertures traversantes ;
iv) formation de métallisations de reprise de contact 121 dans les ouvertures traversantes, chaque métallisation 121 venant contacter individuellement la région dopée de type P 119 sous-jacente, à travers l'ouverture correspondante.

A l'étape i), la couche diélectrique 117 est par exemple déposée par un procédé de dépôt chimique en phase vapeur assisté par plasma (PECVD).

A l'étape ii), les ouvertures traversantes formées dans la couche diélectrique 117 sont par exemple formées par photolithographie et gravure.

A l'étape iii), le dopage des régions 119 peut être réalisé par diffusion ou implantation d'éléments dopants de type P, par exemple du zinc (Zn) ou du béryllium (Be), en vis-à-vis des ouvertures formées à l'étape ii). Un recuit d'activation des éléments dopants peut ensuite être mis en oeuvre. A titre d'exemple, le recuit d'activation peut être un recuit laser superficiel, ce qui permet de ne pas altérer les circuits intégrés 103 ni la qualité du collage entre les circuits intégrés 103 et l'empilement actif de diode photosensible 113. Les régions dopées de type P 119 forment des régions d'anode des diodes photosensibles du dispositif. Dans cet exemple, les régions 119 s'étendent sur toute l'épaisseur de la couche 113a, et viennent en contact, par leur face inférieure, avec la face supérieure de la couche d'absorption 113b.

A l'étape iv), à titre d'exemple, une couche métallique est d'abord déposée de façon continue sur toute la surface supérieure de la structure, c'est-à-dire sur et en contact avec la face supérieure de la couche diélectrique 117 et dans les ouvertures formées à l'étape ii), puis retirée par photolithographie et gravure en conservant les métallisations 121. Dans cet exemple, chaque métallisation 121 constitue une électrode d'anode d'une diode photosensible D1 du dispositif.

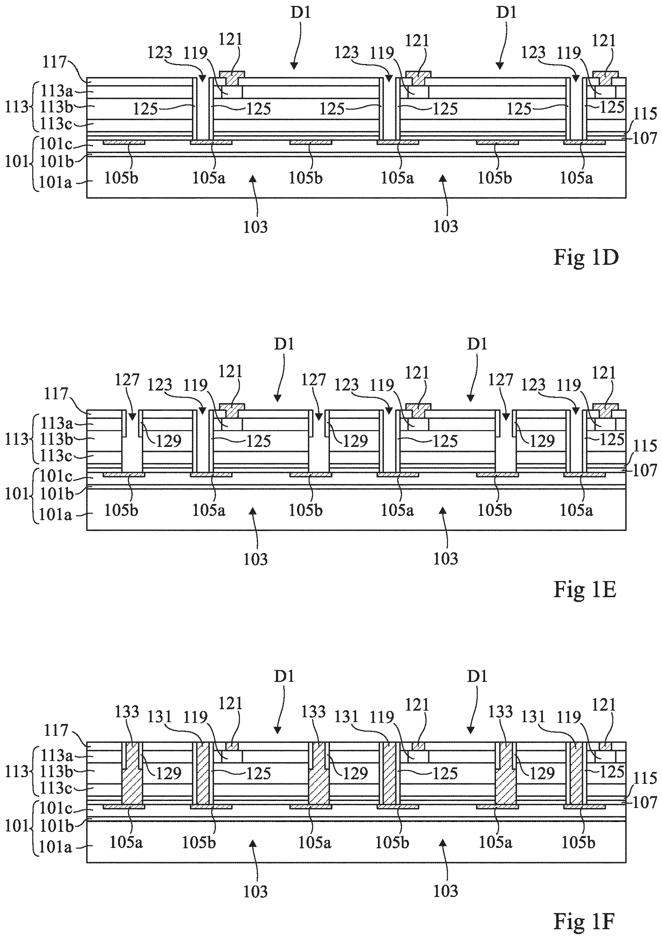

La figure 1D illustre la structure obtenue à l'issue d'une étape de formation, à partir de la face supérieure de la structure, de premières ouvertures ou vias de reprise de contact 123 traversant l'empilement actif de diode photosensible 113 et débouchant sur les plots de connexion d'anode 105a des circuits intégrés de contrôle 103. Les ouvertures 123 s'étendent verticalement depuis la face supérieure de la couche diélectrique 117 jusqu'à la face supérieure des plots 105a, à travers les couches 117, 113a, 113b, 113c, 115 et 107. Les ouvertures 123 ont par exemple une forme circulaire (en vue de dessus, non représentée). Dans cet exemple, on vient former à cette étape, pour chacune des diodes photosensibles D1, une ouverture 123 spécifique formant une ouverture de reprise de contact d'anode de la diode.

La figure 1D illustre en outre une étape de dépôt d'une couche électriquement isolante 125, par exemple en oxyde de silicium, sur les parois latérales des ouvertures 123. La couche 125 est par exemple d'abord déposée de façon continue, par une méthode de dépôt conforme, sur toute la surface supérieure de la structure après la formation des ouvertures 123. Les portions horizontales de la couche 125 sont ensuite retirées par gravure anisotrope verticale de façon que seules subsistent les portions verticales revêtant les parois latérales des ouvertures 123. Ceci permet notamment de libérer l'accès à la face supérieure des plots 105a au fond des ouvertures 123.

La figure 1E illustre la structure obtenue à l'issue d'une étape de formation, à partir de la face supérieure de la structure, de deuxièmes ouvertures ou vias de reprise de contact 127 traversant l'empilement actif de diode photosensible 113 et débouchant sur les plots de connexion de cathode 105b des circuits intégrés de contrôle 103. Les ouvertures 127 s'étendent verticalement depuis la face supérieure de la couche diélectrique 117 jusqu'à la face supérieure des plots 105b, à travers les couches 117, 113a, 113b, 113c, 115 et 107. Les ouvertures 127 ont par exemple une forme circulaire (en vue de dessus, non représentée). Dans cet exemple, on vient former à cette étape, pour chacune des diodes photosensibles D1, une ouverture 127 spécifique formant une ouverture de reprise de contact de cathode de la diode.

La figure 1E illustre en outre une étape de dépôt d'une couche électriquement isolante 129, par exemple en oxyde de silicium, sur une partie supérieure des parois latérales des ouvertures 127. Dans cet exemple, la couche 129 recouvre les flancs de la couche semiconductrice supérieure 113a et une partie supérieure des flancs de la couche semiconductrice intermédiaire 113b de l'empilement 113. La couche isolante 129 laisse en revanche accessible au moins une partie, et de préférence la totalité des flancs de la couche semiconductrice inférieure 113c de l'empilement 113. La couche isolante 129 est par exemple déposée par pulvérisation, en utilisant un système d'inclinaison et de mise en rotation du substrat de façon à déposer le matériau isolant uniquement en partie supérieure des ouvertures 127. La profondeur du dépôt peut être réglée en jouant sur l'inclinaison du substrat par rapport à la direction de pulvérisation. Pendant l'étape de dépôt de la couche isolante 129, les ouvertures 123 sont par exemple protégées au moyen d'un masque, non représenté.

La figure 1F illustre une étape ultérieure de remplissage des ouvertures 123 et 127 par du métal, de façon à former des vias conducteurs 131, respectivement 133. A l'issue de cette étape, une étape de planarisation de la face supérieure de la structure, par exemple une planarisation mécano-chimique (CMP), peut être mise en oeuvre, de sorte que les métallisations 121, 131, 133 affleurent au niveau de la face supérieure de la couche diélectrique 117.

Dans cet exemple, les vias 131 de reprise de contact d'anode des diodes D1 sont isolés des couches de l'empilement 113 par la couche d'isolation latérale 125. Les vias 133 de reprise de contact de cathode des diodes D1 sont isolés de la couche 113a par la couche d'isolation latérale 129 et sont en contact, latéralement, avec la couche de cathode 113c. Les vias 133 connectent électriquement la couche de cathode 113c de l'empilement de diode photosensible aux plots 105b de connexion de cathode des diodes photosensibles D1. A titre de variante, la couche d'isolation latérale supérieure 129 peut être omise. En effet, dans la mesure les couches 113b et 113a de l'empilement 113 sont peu ou pas dopées, le contact latéral entre le via 133 et lesdites couches 113b, 113c n'entraîne pas de court-circuit des diodes D1.

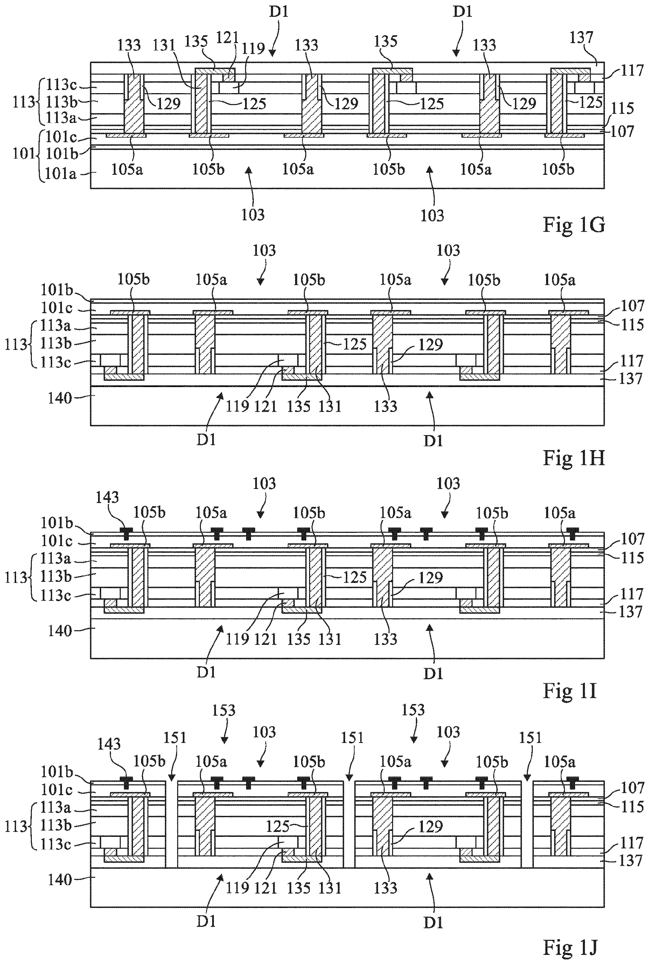

La figure 1G illustre la structure obtenue à l'issue d'une étape de formation de métallisations sur la face supérieure de la structure de la figure 1F. Les métallisations formées à cette étape sont en contact, par leur face inférieure, avec la face supérieure de la couche diélectrique 117 et avec des métallisations 131 et 121 sous-jacentes.

A cette étape, on forme par exemple, pour chaque diode D1, une métallisation 135 connectant électriquement le via de reprise de contact d'anode 131 de la diode D1 à la métallisation de contact d'anode 121 de cette diode.

A titre d'exemple, une couche de métal est d'abord déposée pleine plaque sur toute la surface supérieure de la structure de la figure 1F, puis retirée localement par photolithographie et gravure en conservant les métallisations 135.

La figure 1G illustre en outre une étape ultérieure optionnelle de formation d'une couche de passivation 137, par exemple en un matériau diélectrique, par exemple en oxyde de silicium, sur la face supérieure de la structure obtenue à l'issue de l'étape de formation des métallisations 135. La couche 137 s'étend par exemple de façon continue sur toute la surface supérieure de la structure. A titre d'exemple, la couche 137 présente une surface supérieure sensiblement plane.

La figure 1H illustre une étape ultérieure de report de la structure de la figure 1G sur un substrat de support temporaire 140. Sur la figure 1H, l'orientation de la structure est inversée par rapport à l'orientation de la figure 1G. Le substrat de support temporaire est fixé sur la face de la couche de passivation 137 opposée au substrat 101, c'est-à-dire sa face inférieure dans l'orientation de la figure 1H (correspondant à sa face supérieure dans l'orientation de la figure 1G). Le substrat de support temporaire 140 est par exemple un substrat en silicium. La fixation du substrat de support temporaire 140 sur la couche 137 peut être obtenue au moyen d'une couche adhésive de collage, ou par collage direct.

La figure 1H illustre en outre une étape ultérieure de retrait du substrat de support 101a de la structure SOI de départ, par exemple par meulage et/ou gravure chimique, de façon à libérer l'accès à la face supérieure de la couche isolante 101b de la structure SOI.

On notera que les modes de réalisation décrits ne se limitent pas à l'exemple décrit ci-dessus dans lequel le substrat 101 est un substrat de type SOI. A titre de variante, le substrat 101 peut être un substrat semiconducteur massif, par exemple en silicium. Dans ce cas, à l'étape de la figure 1A, le substrat 101 peut être aminci par sa face arrière (face supérieure dans l'orientation de la figure 1H), par exemple par meulage. Une couche isolante de passivation, par exemple en oxyde de silicium, peut ensuite être déposée sur la face supérieure du substrat aminci, remplaçant la couche 101b du substrat SOI. A titre de variante, la couche 101b peut être omise ou retirée.

La figure 1I illustre la structure obtenue à l'issue d'étapes de formation d'ouvertures de reprise de contact dans les couches 101b et 101c, et de formation de métallisations de reprise de contact 143 dans et sur lesdites ouvertures. Les métallisations 143 permettent de reprendre des contacts électriques sur des niveaux métalliques (non détaillés sur les figures) de l'empilement d'interconnexion disposé du côté de la face inférieure de la couche semiconductrice 101c. Les métallisations 131 sont par exemple connectées électriquement à des transistors du circuit de contrôle, ces transistors étant eux-mêmes connectés ou reliés électriquement à des métallisations de connexion 105a, 105b des diodes D1.

Les métallisations 143 forment des bornes de connexion des futures puces élémentaires de pixel du dispositif, destinées à être connectées à des bornes de connexion correspondantes du substrat de report du dispositif.

La figure 1J illustre la structure obtenue à l'issue d'une étape de singularisation des puces élémentaires de pixel du dispositif. Pour cela, des tranchées 151 s'étendant verticalement à travers les couches 101b, 101c, 107, 115, 113a, 113b, 113c, 117 et 137 sont formées à partir de la face supérieure de la structure, selon des lignes de découpe. Dans cet exemple, les tranchées débouchent sur la face supérieure du substrat de support temporaire 140. En vue de dessus, les tranchées 151 forment une grille continue délimitant latéralement une pluralité de puces élémentaires de pixel 153, par exemple identiques ou similaires, comportant chacune un circuit de contrôle élémentaire 103 et une ou plusieurs diodes photosensibles D1 (une unique diode D1 dans l'exemple représenté). Les tranchées 151 sont par exemple réalisées par gravure plasma.

A titre de variante, non représentée, des étapes de formation de filtres optiques peuvent être prévues, par exemple après le dépôt de la couche de passivation 137 et avant la fixation du substrat de support temporaire 140. Ainsi, chaque diode photosensible D1 peut être revêtue, du côté de sa face d'exposition à la lumière, à savoir sa face inférieure dans l'orientation de la figure 1J, d'un filtre optique, par exemple un filtre passe-bande, permettant de filtrer le rayonnement éclairant la diode D1. La réalisation de tels filtres optiques est à la portée de la personne du métier à la lecture de la présente description.

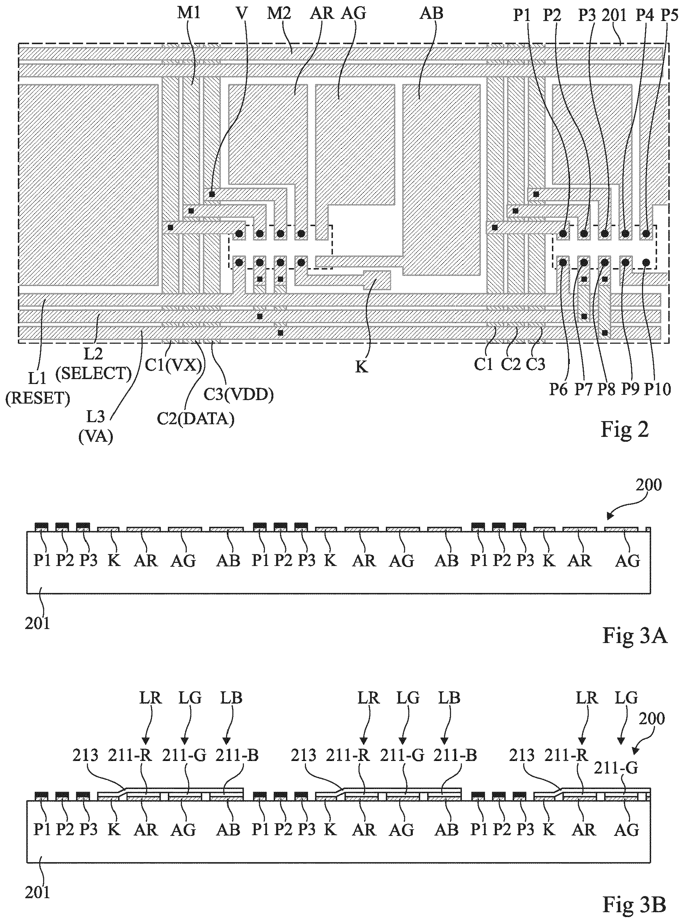

Les puces élémentaires de pixel 153 sont destinées à être reportées sur un substrat de report 200 du dispositif de capture, comme cela sera décrit plus en détail ci-après en relation avec les figures 3A à 3D.

La figure 2 est une vue de dessus schématique et partielle d'un exemple de réalisation du substrat de report 200 du dispositif d'affichage.

Sur la figure 2, seule une portion du substrat de report, correspondant à deux pixels adjacents d'une même ligne du dispositif d'affichage, a été représentée.

Le substrat de report 200 comprend par exemple une plaque ou feuille de support 201 en un matériau isolant, par exemple en verre ou en plastique. A titre de variante, la plaque ou feuille de support 201 comprend un support conducteur, par exemple métallique, recouvert par une couche d'un matériau isolant. Le substrat de report comprend en outre des éléments de connexion électrique, et en particulier des pistes conductrices et des plages conductrices, formés sur la face supérieure de la plaque de support 201. Ces éléments de connexion électrique sont par exemple formés par impression d'une succession de niveaux conducteurs et isolants sur la face supérieure de la plaque de support 201. Les éléments de connexion électrique sont par exemple formés par un procédé de dépôt ou d'impression de type impression jet d'encre, par sérigraphie, par rotogravure, par dépôt sous vide, ou par toute autre méthode adaptée.

Dans l'exemple représenté, le substrat de report 201 comprend deux niveaux métalliques conducteurs M1 et M2 séparés par un niveau isolant (non visible sur la figure), et des vias métalliques V connectant les deux niveaux métalliques à travers le niveau isolant. Dans cet exemple, le substrat de report 201 comprend en outre des plages métalliques de connexion formées sur le niveau métallique supérieur M2, destinées à être connectées à des plages de connexion 143 correspondantes des puces élémentaires de pixel 153 du dispositif.

Des circuits actifs de commande du dispositif d'affichage, adaptés à alimenter et commander les puces élémentaires du dispositif par l'intermédiaire des éléments de connexion électrique du substrat de report, sont par exemple connectés aux éléments de connexion électrique du substrat de report à la périphérie du substrat de report 200.

Dans l'exemple représenté, la fabrication du substrat de report comprend les trois étapes successives de dépôt suivantes.

Lors d'une première étape de dépôt, on forme sur la face supérieure de la plaque de support 201 une pluralité de pistes conductrices sensiblement parallèles à la direction des colonnes du dispositif d'affichage (direction verticale dans l'orientation de la figure 2). Plus particulièrement, dans cet exemple, lors de la première étape de dépôt, on forme, pour chaque colonne du dispositif d'affichage, trois pistes conductrices C1, C2 et C3 s'étendant sur sensiblement toute la longueur des colonnes du dispositif d'affichage. Les pistes C1 sont destinées à véhiculer un signal VX représentatif de l'intensité lumineuse reçue par les photodétecteurs des puces élémentaires 153 de la colonne. Les pistes C2 sont destinées à véhiculer un signal DATA de réglage de l'intensité lumineuse émise par les LED des pixels de la colonne. Les pistes C3 sont destinées à distribuer un potentiel d'alimentation haut VDD aux différentes puces élémentaires de pixel 153.

Les éléments conducteurs formés lors de cette première étape de dépôt définissent le premier niveau conducteur M1 du substrat de report.

Lors d'une deuxième étape de dépôt, on recouvre le premier conducteur d'un matériau isolant (non visible sur la figure), de façon à permettre le dépôt ultérieur de pistes conductrices s'étendant au-dessus des pistes C1, C2 et C3, sans créer de court-circuit avec les pistes C1, C2 et C3.

Lors d'une troisième étape de dépôt, on forme sur la face supérieure de la plaque de support 201, une pluralité de pistes conductrices sensiblement parallèles à la direction des lignes du dispositif d'affichage. Plus particulièrement, dans cet exemple, lors de la troisième étape de dépôt, on imprime, pour chaque ligne du dispositif d'affichage, trois pistes conductrices L1, L2 et L3 s'étendant sur sensiblement toute la longueur des lignes du dispositif d'affichage. Les pistes L1 sont destinées à véhiculer un signal RESET de commande de réinitialisation des photodétecteurs de la ligne de pixel correspondante. Les pistes L2 sont destinées à véhiculer un signal SELECT de sélection des photodétecteurs et/ou des LED de la ligne de pixel correspondante. Les pistes L3 sont destinées à distribuer un potentiel de polarisation fixe VA, par exemple inférieur au potentiel VDD, aux différentes puces élémentaires de pixel 153.

Dans cet exemple, le dispositif que l'on cherche à réaliser comprend, pour chaque puce élémentaire de pixel 153, trois LED organiques LR, LG, LB définissant respectivement un sous-pixel d'émission de lumière rouge, un sous-pixel d'émission de lumière verte et un sous-pixel d'émission de lumière bleue du dispositif.

Dans cet exemple, lors de la troisième étape de dépôt, sont en outre imprimées, pour chaque pixel du dispositif, trois régions métalliques AR, AG, AB, définissant les électrodes d'anode respectives des LED organiques LR, LG, LB du pixel. De plus, dans cet exemple, lors de la troisième étape de dépôt, est en outre imprimée, pour chaque pixel du dispositif, une région métallique K définissant une plage de reprise de contact de cathode commune aux LED organiques LR, LG, LB du pixel.

Les éléments conducteurs imprimés lors de cette troisième étape de dépôt définissent le deuxième niveau conducteur M2 du substrat de report.

Après la troisième étape de dépôt, on vient former, pour chaque pixel, sur des zones conductrices du niveau métallique M2, dix plages métalliques P1, P2, P3, P4, P5, P6, P7, P8, P9 et P10 destinées à recevoir respectivement dix plages de connexion 143 distinctes de la puce élémentaire 153 du pixel. Les plages P1, P2, P3 sont connectées respectivement aux pistes conductrices C1, C2 et C3 de la colonne de pixels correspondante. Les plages P4 et P5 sont connectées respectivement aux électrodes AR et AG du pixel. Les plages P6, P7, P8 sont connectées respectivement aux pistes conductrices L1, L2, L3 de la ligne de pixels correspondante. Les plages P9 et P10 sont connectées respectivement aux électrodes K et AB du pixel.

Les vias V reliant les niveaux métalliques inférieur M1 et supérieur M2 sont ouverts dans le niveau isolant séparant les niveaux M1 et M2, avant la formation du niveau supérieur M2.

Les figures 3A à 3D sont des vues en coupe illustrant des étapes successives d'un exemple d'un procédé de fabrication d'un dispositif de capture d'images mixte.

Par souci de simplification, sur les figures 3A à 3D, les puces élémentaires 153 et le substrat de report 200 ont été représentés de façon très schématique, et de nombreux éléments ont été omis par rapport aux représentations des figures 1J et 2.

Les figures 3A et 3B illustrent plus particulièrement une étape de formation des LED organiques LR, LG, LB des pixels du dispositif.

La figure 3A représente de façon simplifiée le substrat de support 200 de la figure 2

La figure 3B illustre la structure obtenue à l'issue d'étapes de dépôt de couches actives semiconductrices émissives organiques 211-R, 211-G, 211-B respectivement sur et en contact avec les électrodes d'anode AR, AG, AB de chaque pixel, et de dépôt d'une électrode supérieure commune 213 sur et en contact avec les couches actives 211-R, 211-G, 211-B.

Les couches actives 211-R, 211-G, 211-B sont déposées successivement, de façon localisée, respectivement sur les électrodes AR, AG, AB de chaque pixel, par exemple par évaporation au travers d'un pochoir ("shadow mask" en anglais). A titre de variante, les couches actives 211-R, 211-G, 211-B sont déposées successivement par un procédé d'impression localisée, par exemple par impression jet d'encre, par sérigraphie ou par un procédé de revêtement par filière à fente ("slot-die coating" en anglais). Dans chaque sous-pixels d'émission, la portion de couche active organique 211-R, 211-G, 211-B du sous-pixel s'étend par exemple sur toute la surface supérieure de l'électrode AR, respectivement AG, respectivement AB correspondante. Les couches actives 211-R, 211-G et 211-B sont par exemple adaptées à émettre majoritairement respectivement de la lumière rouge, de la lumière verte, et de la lumière bleue, et optionnellement un rayonnement infrarouge.

La couche d'électrode supérieure 213 s'étend de façon continue sur et en contact avec la face supérieure des couches actives 211-R, 211-G, 211-B. La couche d'électrode supérieure 213 s'étend en outre sur et en contact avec la face supérieure de la région métallique de reprise de contact de cathode K commune aux LED LR, LG, LB. La couche d'électrode supérieure 213 est transparente aux longueurs d'onde d'émissions des LED LR, LG, LB. A titre d'exemple, la couche d'électrode supérieure 213 est en un oxyde conducteur transparent, par exemple en oxyde d'indium-étain (ITO). La couche d'électrode supérieure 213 peut être déposée de façon localisée, pour chaque pixel, au-dessus des couches actives 211-R, 211-G, 211-B et de la région métallique K du pixel, par exemple par évaporation au-travers d'un pochoir. En particulier, la couche 213 ne s'étend pas au-dessus des plages métalliques P1, P2, P3, P4, P5, P6, P7, P8, P9, P10 ni au-dessus des pistes conductrices L1, L2, L3, de façon à ne pas court-circuiter ces éléments.

A l'issue de ces étapes, les LED organiques LR, LG, LB sont formées. La LED LR est constituée par l'empilement des couches AR, 211-R et 213. La LED LG est constituée par l'empilement des couches AG, 211-G et 213. La LED LB est constituée par l'empilement des couches AB, 211-B et 213.

Après le dépôt de la couche d'électrode supérieure 213, une couche isolante transparente d'encapsulation, non représentée, est de préférence déposée sur la face supérieure des LED organiques. La couche de protection est par exemple en alumine (Al₂O₃) ou en oxyde de silicium. Dans cet exemple, la couche d'encapsulation ne recouvre pas les plages métalliques de contact P1, P2, P3, P4, P5, P6, P7, P8, P9, P10, de façon à permettre la connexion ultérieure des puces élémentaires 153 sur ces plages.

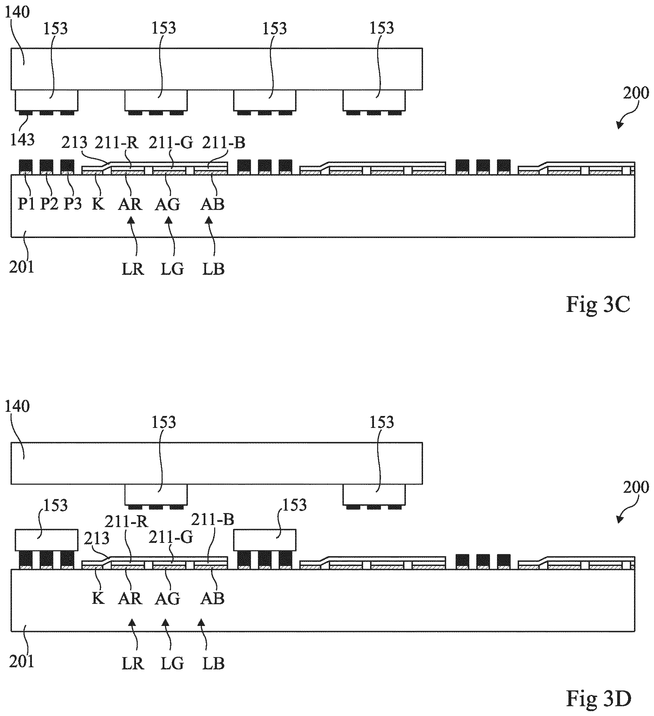

Les figures 3C et 3D illustrent plus particulièrement une étape de transfert collectif de puces élémentaires de pixel 153 sur le substrat de report 200.

Les puces élémentaires 153 sont initialement fixées à une face du substrat de support temporaire 140. La structure comportant le substrat de support temporaire 140 et les puces élémentaires 153 est par exemple réalisée par un procédé du type décrit en relation avec les figures 1A à 1J. Dans l'exemple représenté, la structure est retournée par rapport à l'orientation de la figure 1J, c'est-à-dire que les puces élémentaires 153 sont disposées du côté de la face inférieure du substrat de support temporaire 140.

Les puces élémentaires 153 sont rapportées collectivement en vis-à-vis de la face de connexion du substrat de report 200, à savoir sa face supérieure dans l'orientation des figures 3C et 3D, en utilisant le substrat de support temporaire 140 comme poignée (figure 3C).

Les bornes de connexion 143 de puces élémentaires 153, situées du côté de la face inférieure desdites puces, sont alors mises en contact avec les plages de connexion correspondantes P1, P2, P3, P4, P5, P6, P7, P8, P9, P10 du substrat de report 200, et fixées auxdites plages de connexion P1, P2, P3, P4, P5, P6, P7, P8, P9, P10. La fixation des bornes de connexion 143 des puces élémentaires 153 aux plages de connexion du substrat de report est par exemple réalisée par collage direct, par thermocompression, par brasure, au moyen de microstructure métalliques (par exemple des micro-piliers) préalablement formées sur les bornes 143, ou par toute autre méthode de fixation et de connexion adaptée.

Une fois fixées, par leurs bornes de connexion 143, au substrat de report 200, les puces élémentaires 153 sont détachées du substrat de support temporaire 140 et ce dernier est retiré (figure 3D), libérant l'accès à la face d'éclairement des photodétecteurs D1 (non détaillées sur les figures 3C et 3D).

Le pas des puces élémentaires 153 sur le substrat de report 200 peut être supérieur au pas des micropuces élémentaires 153 sur le substrat de support temporaire 140. De préférence, le pas des puces élémentaires 153 sur le substrat de report 200 est un multiple du pas des micropuces élémentaires 153 sur le substrat de support temporaire 140. Dans ce cas, seule une partie des puces 153 est prélevée sur le substrat de support 140 à chaque transfert, comme illustré sur les figures 3C et 3D. Les autres puces 153 restent solidaires du substrat de support temporaire 140 et peuvent être utilisées lors d'une autre étape de report collectif pour peupler une autre partie du substrat de report 200 ou un autre substrat de report.

Dans cet exemple, les LED organiques LR, LG, LB sont formées avant le report des puces élémentaires 153 sur le substrat de report 200. A titre de variante, les LED organiques LR, LG, LB peuvent être formées après le report des puces élémentaires 153 sur le substrat 200. Dans ce cas, la couche d'encapsulation des LED organiques peut s'étendre de façon continue sur toute la surface supérieure du dispositif, c'est-à-dire non seulement sur les LED organiques mais aussi sur la face supérieure et sur les flancs des puces élémentaires 153.

Des systèmes optiques (par exemple des lentilles de focalisation de l'image captée) peuvent être rajoutées dur les dispositifs de capture.

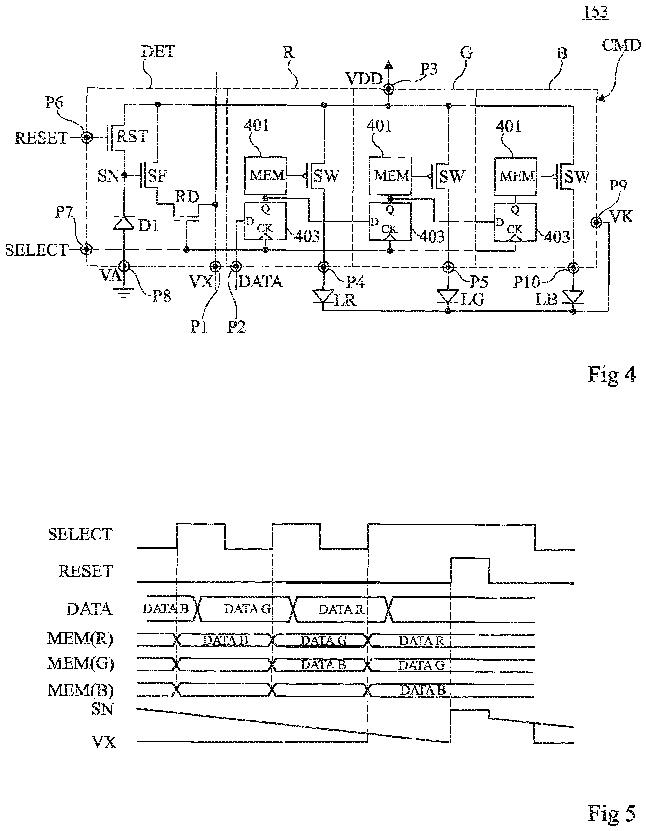

La figure 4 est un schéma électrique des circuits d'un exemple d'une puce élémentaire de pixel 153 d'un dispositif de capture mixte du type décrit ci-dessus.

Dans cet exemple, la puce 153 est une puce à 10 bornes ou plots de connexion 143 connectés respectivement aux dix plages de connexion P1, P2, P3, P4, P5, P6, P7, P8, P9 et P10 du substrat de support 200 de la figure 2.

La puce 153 de la figure 4 comprend un pixel de détection DET adapté à mesurer une intensité d'un rayonnement lumineux reçu par la puce, par exemple un rayonnement infrarouge. Le pixel de détection DET comprend le photodétecteur D1, et un circuit de lecture d'un signal représentatif d'une intensité lumineuse reçue par le photodétecteur D1. La puce 153 comprend en outre un circuit CMD de commande des LED organiques LR, LG, LB définissant les sous-pixels d'émission associés à la puce. Plus particulièrement, le circuit de commande CMD comprend trois circuits de commande élémentaires R, G et B adaptés à commander respectivement les LED LR, LG et LB.

Dans cet exemple, chacun des sous-circuits de commande R, G et B comprend un transistor MOS SW ayant un premier noeud de conduction relié, par exemple connecté, à la borne P3 d'application du potentiel d'alimentation haut VDD, et un deuxième noeud de conduction relié, par exemple connecté, à la borne d'anode P4, respectivement P5, respectivement P10 de la LED LR, respectivement LG, respectivement LB correspondante. Dans cet exemple, les transistors SW sont des transistors MOS à canal P, chaque transistor SW ayant sa source reliée, par exemple connectée, à la borne P3 et son drain relié, par exemple connecté, à l'anode de la LED 123 du sous-pixel.

Les cathodes des LED LR, LG, LB peuvent être connectées à la borne P9 de la puce, fournissant un potentiel de polarisation fixe VK, inférieur au potentiel VDD. La puce 153 peut comprendre un circuit, non détaillé, de fourniture du potentiel VK. En variante, les bornes P8 et P9 peuvent être reliées, le potentiel VK de cathode des LED LR, LG, LB étant alors égal au potentiel VA d'anode de la diode photosensible D1. Dans une autre variante, la borne P9 peut être omise, le potentiel VK étant distribué sur les métallisations K des pixels par l'intermédiaire de pistes conductrices de colonne ou de ligne formées dans le niveau de métallisations M1 ou M2 du substrat de report 200.

Dans cet exemple, les LED LR, LG, LB sont commandées au moyen de signaux de consigne numériques à codage binaire, par exemple selon un procédé de commande de type PWM (de l'anglais "Pulse Width Modulation" - modulation en largeur d'impulsion), par exemple du type décrit dans la demande de brevet EP3079142 précédemment déposée par le demandeur. Chacun des sous-circuits de commande R, G et B comprend un circuit mémoire 401 (MEM), par exemple une mémoire SRAM (de l'anglais "Statique Random Access Memory" - mémoire statique à accès aléatoire) ou une bascule de type D, adapté à mémoriser une suite de valeurs binaires (0 ou 1) définissant respectivement un état bloqué ou passant du transistor SW, et donc un état éteint ou allumé de la LED LR, respectivement LG, respectivement LB associée. A titre de variante, le circuit mémoire 401 peut comprendre un simple interrupteur et une capacité à faible fuite. Chaque circuit mémoire comprend un noeud de sortie relié, par exemple connecté, à un noeud de commande (grille) du transistor SW. Dans cet exemple, chacun des sous-circuits de commande R, G et B comprend en outre une bascule D 403 ayant un noeud d'entrée de données D, un noeud de sortie de données Q relié, par exemple connecté, à un noeud d'entrée du circuit mémoire 401 du sous-circuit, et un noeud de commande CK relié, par exemple connecté, à la borne P7 d'application du signal de commande SELECT. Dans cet exemple, les bascules 403 des sous-circuits R, G et B de la puce sont reliées en série. Plus particulièrement, dans l'exemple représenté, la bascule 403 du sous-circuit de commande R a son noeud d'entrée de données D relié, par exemple connecté, à la borne P2 d'application du signal de données d'émission DATA, la bascule 403 du sous-circuit de commande G a son noeud d'entrée de données D relié, par exemple connecté, au noeud Q de sortie de la bascule 403 du sous-circuit de commande R, et la bascule 403 du sous-circuit de commande B a son noeud d'entrée de données D relié, par exemple connecté, au noeud Q de sortie de la bascule 403 du sous-circuit de commande G.

Dans cet exemple, le circuit READ de lecture du pixel de détection DET comprend trois transistors MOS à canal N RST, SF et RD. Le transistor RST a son drain relié, par exemple connecté, à la borne P3 d'application du potentiel d'alimentation haut VDD et sa source reliée, par exemple connectée, à la cathode du photodétecteur D1. Dans cet exemple, la grille du transistor RST est connectée à la borne P6 d'application du signal de réinitialisation RESET du pixel. Le transistor SF a son drain relié, par exemple connecté, à la borne P3 et sa source reliée, par exemple connectée, au drain du transistor RD. Le transistor SF a sa grille reliée, par exemple connectée, à la source du transistor RST. Le transistor RD a sa source reliée, par exemple connectée, à la borne P1 de fourniture du signal de sortie VX du photodétecteur. La grille du transistor RD est reliée, par exemple connectée, à la borne P7 d'application du signal de commande SELECT.

La figure 5 est un diagramme illustrant de façon schématique le fonctionnement de la puce élémentaire de pixel 153 de la figure 4. La figure 5 représente plus particulièrement l'évolution, en fonction du temps, des signaux SELECT, RESET, DATA, VX, ainsi que du potentiel SN du noeud de grille du transistor SF, et des signaux MEM(R), MEM(G) et MEM(B) contenus respectivement dans les mémoires MEM des sous-circuits de commande R, G et B.

Dans cet exemple, les signaux de consigne d'émission respectifs DATA R, DATA G et DATA B des LED LR, LG et LB sont des signaux numériques multiplexés temporellement sur la borne P2 (signal DATA). A chaque front montant du signal SELECT, un bit de donnée d'émission du signal DATA est transmis de la borne P2 à la mémoire 401 du sous-circuit de commande R, le bit de données d'émission précédent est transmis de la borne de sortie Q de la bascule D 403 du sous-circuit de commande R à la mémoire 401 du sous-circuit de commande G, et le bit de données d'émission précédent est transmis de la borne de sortie Q de la bascule D 403 du sous-circuit de commande G à la mémoire 401 du sous-circuit de commande B. Ainsi, trois périodes du signal SELECT sont nécessaires pour transmettre trois signaux de consigne respectivement aux trois sous-circuits de commande R, G et B du dispositif.

Dans cet exemple, le signal RESET permet de commander le transistor de réinitialisation RST du circuit de lecture du pixel de détection DET. Ceci permet, à chaque lecture, d'échantillonner une première valeur du signal VX à la fin d'une période d'intégration pendant laquelle le transistor de réinitialisation RST est maintenu bloqué, puis une deuxième valeur du signal VX immédiatement après une période de réinitialisation du photodétecteur D1 pendant laquelle le transistor de réinitialisation RST est maintenu passant (la fin de la période de réinitialisation marquant le début d'une deuxième période d'intégration). La différence entre les deux valeurs lues définit la valeur de sortie du pixel. On réalise ainsi une lecture à échantillonnage double.

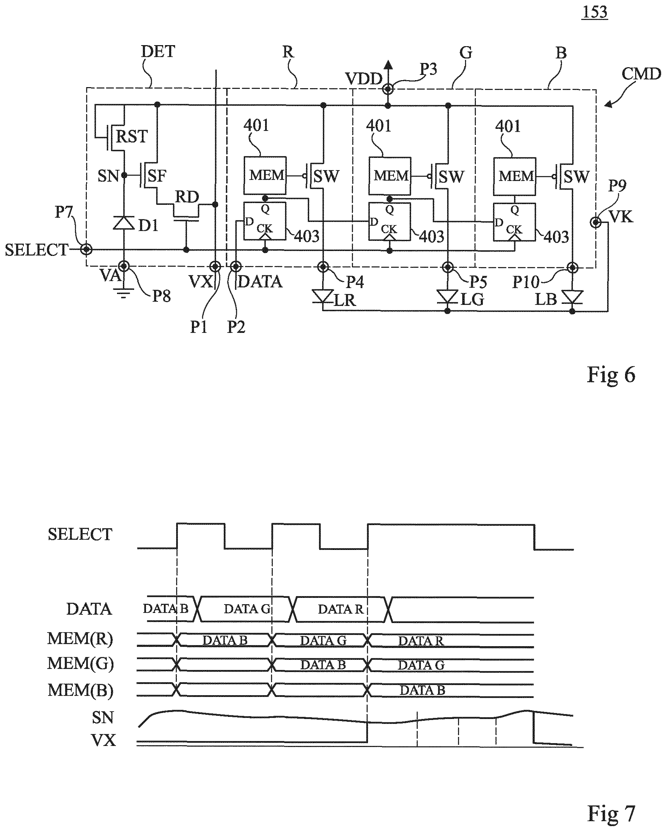

La figure 6 est un schéma électrique des circuits d'un autre exemple d'une puce élémentaire de pixel 153 d'un dispositif d'affichage interactif du type décrit ci-dessus.

La puce élémentaire 153 de la figure 6 diffère de la puce élémentaire 153 de la figure 4 essentiellement en ce qu'elle ne comprend pas la borne P6 d'application du signal de réinitialisation RESET.

Dans l'exemple de la figure 6, la grille du transistor RST est connectée au drain de ce même transistor. Autrement dit, le transistor RST est monté en diode.

La figure 7 est un diagramme illustrant de façon schématique le fonctionnement de la puce élémentaire de pixel 153 de la figure 6. La figure 7 représente plus particulièrement l'évolution, en fonction du temps, des signaux SELECT, DATA, VX, ainsi que du potentiel SN du noeud de grille du transistor SF, et des signaux MEM(R), MEM(G) et MEM(B) contenus respectivement dans les mémoires MEM des sous-circuits de commande R, G et B.

La configuration en diode du transistor RST fonctionnant en régime de faible inversion implique une réponse logarithmique de la tension sur sa source en fonction du courant qui traverse son canal, dans ce cas le photo-courant généré par la photodiode D1. Ainsi, le circuit de lecture du pixel de détection DET met en oeuvre une lecture logarithmique du photo-courant généré par le photodétecteur D1. A chaque période d'activation du signal SELECT, le transistor RD est rendu passant. Le signal VX fourni sur la borne de sortie P1 est alors une tension analogique représentative de la luminosité instantanée reçue par le photodétecteur D1 du pixel. Le signal VX peut être lu et numérisé en pied de colonne. A titre d'exemple, à chaque mise à jour des signaux de consigne d'émission des sous-circuit de commande R, G et B de la puce, le signal VX du pixel peut être lu successivement trois fois et une moyenne des trois valeurs peut être réalisée, de façon à minimiser le bruit de lecture.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples particuliers de réalisation des puces élémentaires de pixel et du substrat de report décrits en relation avec les figures 1A à 1J, 2 et 3A à 3D.

En outre, les modes de réalisation décrits ne se limitent pas aux exemples particuliers de réalisation des circuits électroniques de contrôle (commande de l'émission de lumière de LED ou de l'élément d'actuation ou lecture de l'élément de capture ou d'actuation) des puces élémentaires de pixel décrits en relation avec les figures 4 à 7.

De plus, les modes de réalisation décrits ne se limitent pas au cas particulier décrit ci-dessus dans lequel les LED du dispositif sont des LED organiques. A titre de variante, les LED organiques du dispositif décrit peuvent être remplacés par des LED inorganiques, par exemple à base de matériaux semiconducteurs de type III-V, par exemple à base de nitrure de gallium.

Plus généralement, les LED peuvent être remplacées, toutes ou en partie, par tout autre élément de capture ou d'actuation externes aux puces 153. Ces éléments de capture ou d'actuation peuvent être de tout type. Un exemple non limitatif de tels éléments peut être, par exemple, des transducteurs ultrasonores ou acoustiques, par exemple de type piézoélectrique. Ceci permet par exemple de mettre en oeuvre des fonctions de détection de toucher ou de proximité d'un objet, par exemple la main d'un utilisateur, par exemple en utilisant l'effet piézoélectrique direct, et/ou des fonctions de stimulation haptique, et/ou des fonctions d'émission d'ondes acoustiques directives, par exemple en utilisant l'effet piézoélectrique indirect.

Ainsi, par fonction d'actuation, on entend, par exemple, l'actionnement d'actionneurs piézoélectriques afin de générer une onde ultrasonore ou un mode de vibration apte à provoquer un effet haptique sensible à l'utilisateur.

A titre d'exemple, tout ou une partie des photodétecteur peuvent être remplacés par des actionneurs piézoélectriques comprenant chacun un empilement :
- d'une électrode inférieure, par exemple métallique, par exemple en argent, en molybdène, en platine, en or ou en un alliage d'un ou plusieurs de ces matériaux,
- d'une couche d'un matériau piézoélectrique, par exemple du titano-zirconiate de plomb (PZT), du nitrure d'aluminium (AlN), ou tout autre matériau piézoélectrique, et
- d'une électrode supérieure, par exemple métallique, par exemple en argent, en molybdène, en platine, en ruthénium, en or, ou en un alliage d'un ou plusieurs de ces matériaux.

L'application d'un champ électrique entre l'électrode supérieure et l'électrode inférieure induit une déformation du matériau piézoélectrique. Suivant le signal envoyé, par exemple sinusoïdal à une fréquence définie comme étant la fréquence de travail dimensionnée, l'actionneur génère une onde ultrasonore ou un mode de vibration (par exemple type mode de flexion, ou un mode de Lamb antisymétrique), par exemple apte à générer un effet haptique. Cet effet peut résulter d'une variation du coefficient de friction, notamment si le mode de vibration généré est un mode de Lamb.

Les circuits électroniques de contrôle des puces élémentaires 153 sont alors remplacés par des circuits électroniques de commande des éléments de capture ou d'actuation, par exemple des circuits de commande des transducteurs ultrasonores en émission et/ou en réception.

A titre de variante, les éléments de capture ou d'action externes aux puces 153 peuvent être des photodétecteurs de nature différente des photodétecteurs D1, par exemple des photodétecteurs organiques. Les circuits électroniques de contrôle des puces élémentaires 153 comprennent alors des circuits de lecture des photodétecteurs externes.

Enfin, la mise en oeuvre pratique des modes de réalisation et variantes décrits est à la portée de la personne du métier à partir des indications fonctionnelles données ci-dessus. L'étendue de protection du brevet est déterminée par les revendications.

## Revendications

1. Dispositif comportant :
- un substrat de report (200) comportant des éléments de connexion électrique ; et
- une pluralité de puces élémentaires (153) fixées et connectées électriquement au substrat de report (200), chaque puce élémentaire (153) comportant au moins un photodétecteur (D1) et un circuit électronique de lecture dudit au moins un photodétecteur (D1),
le dispositif comportant en outre, associé à au moins une puce élémentaire (153), un élément (LR, LG, LB) d'émission, de capture ou d'actuation externe à la puce élémentaire (153), fixé et connecté électriquement au substrat de report (200), **caractérisé en ce que** chaque puce élémentaire (153) comporte un circuit électronique de contrôle de l'élément (LR, LG, LB) d'émission, de capture ou d'actuation associé à la puce.

2. Dispositif selon la revendication 1, dans lequel, dans chaque puce élémentaire (153), le circuit électronique de lecture dudit au moins un photodétecteur (D1) et le circuit électronique de contrôle de l'élément d'émission, de capture ou d'actuation (LR, LG, LB) associé à la puce comprennent des transistors MOS formés dans et sur une couche (103c) de silicium monocristallin.

3. Dispositif selon la revendication 1 ou 2, dans lequel, dans chaque puce élémentaire (153), ledit au moins un photodétecteur (D1) est un photodétecteur inorganique à base d'un matériau semiconducteur III-V.

4. Dispositif selon la revendication 3, dans lequel, dans chaque puce élémentaire (153), ledit au moins un photodétecteur (D1) comprend une couche d'absorption en arséniure d'indium gallium.

5. Dispositif selon l'une quelconque des revendications 1 à 4, dans lequel l'élément d'émission, de capture ou d'actuation comprend au moins une diode électroluminescente (LR, LG, LB) .

6. Dispositif selon la revendication 5, dans lequel ladite au moins une diode électroluminescente (LR, LG, LB) est une diode électroluminescente organique.

7. Dispositif selon la revendication 5 ou 6, dans lequel chaque élément d'émission, de capture ou d'actuation comprend trois diodes électroluminescentes (LR, LG, LB) définissant respectivement trois sous-pixels d'émission, et dans lequel chaque puce élémentaire (153) comprend une pluralité de sous-circuits de commande (R, G, B) adaptés à commander individuellement respectivement les trois diodes électroluminescentes (LR, LG, LB).

8. Dispositif selon la revendication 7, dans lequel les trois sous-pixels d'émission sont adaptés à émettre respectivement dans trois gammes de longueurs d'ondes différentes.

9. Dispositif selon la revendication 7 ou 8, dans lequel, dans chaque puce élémentaire (153), les trois sous-circuits de commande (R, G, B) sont reliés à une même borne d'entrée (143) de la puce, connectée à une plage de connexion correspondante (P2) du substrat de report (200), destinée à recevoir séquentiellement des signaux de consigne d'émission (DATA R, DATA G, DATA B) des trois diodes électroluminescentes.

10. Dispositif selon l'une quelconque des revendications 1 à 4, dans lequel l'élément de capture ou d'actuation associé à chaque puce élémentaire (153) est un transducteur piézoélectrique.

## Patentansprüche

1. Vorrichtung, die Folgendes aufweist:
- ein Transfersubstrat (200) mit elektrischen Verbindungselementen; und
- eine Vielzahl von Elementarchips (153), die an das Transfersubstrat (200) gebondet und mit diesem elektrisch verbunden sind, wobei jeder Elementarchip (153) mindestens einen Fotodetektor (D1) und eine elektronische Schaltung zum Auslesen des mindestens einen Fotodetektors (D1) aufweist,
wobei die Vorrichtung außerdem ein mindestens einem Elementarchip (153) zugeordnetes Emissions-, Einfang- oder Betätigungselement (LR, LG, LB) außerhalb des Elementarchips (153) aufweist, das an dem Transfersubstrat (200) fixiert und mit diesem elektrisch verbunden ist, **dadurch gekennzeichnet, dass** jeder Elementarchip (153) eine elektronische Schaltung zur Steuerung des dem Chip zugeordneten Emissions-, Einfang- oder Betätigungselements (LR, LG, LB) aufweist.

2. Vorrichtung nach Anspruch 1, wobei in jedem Elementarchip (153) die elektronische Schaltung zum Auslesen des mindestens einen Fotodetektors (D1) und die elektronische Schaltung zum Steuern des dem Chip zugeordneten Emissions-, Einfang- oder Betätigungselements (LR, LG, LB) MOS-Transistoren aufweisen, die innerhalb und auf einer einkristallinen Siliziumschicht (103c) ausgebildet sind.

3. Vorrichtung nach Anspruch 1 oder 2, wobei in jedem Elementarchip (153) der mindestens eine Photodetektor (D1) ein anorganischer Photodetektor auf der Basis eines III-V-Halbleitermaterials ist.

4. Vorrichtung nach Anspruch 3, wobei in jedem Elementarchip (153) der mindestens eine Photodetektor (D1) eine Indium-Gallium-Arsenid-Absorptionsschicht aufweist.

5. Vorrichtung nach einem der Ansprüche 1 bis 4, wobei das Emissions-, Einfang- oder Betätigungselement mindestens eine lichtemittierende Diode (LR, LG, LB) aufweist.

6. Vorrichtung nach Anspruch 5, wobei die mindestens eine lichtemittierende Diode (LR, LG, LB) eine organische lichtemittierende Diode ist.

7. Vorrichtung nach Anspruch 5 oder 6, wobei jedes Emissions-, Einfang- oder Betätigungselement drei Leuchtdioden (LR, LG, LB) aufweist, die jeweils drei Emissions-Subpixel definieren, und wobei jeder Elementar-Chip (153) eine Vielzahl von Steuer-Subschaltungen (R, G, B) aufweist, die geeignet sind, individuell die jeweiligen drei Leuchtdioden (LR, LG, LB) zu steuern.

8. Vorrichtung nach Anspruch 7, wobei die drei Emissions-Subpixel jeweils in drei verschiedenen Wellenlängenbereichen emittieren können.

9. Vorrichtung nach Anspruch 7 oder 8, wobei in jedem Elementarchip (153) die drei Steuer-Subschaltungen (R, G, B) an einen gleichen Eingangsanschluss (143) des Chips gekoppelt sind, der mit einem entsprechenden Verbindungsbereich (P2) des Transfersubstrats (200) verbunden ist, der dazu bestimmt ist, sequentiell Emissionsbefehlssignale (DATA R, DATA G, DATA B) für die drei Leuchtdioden zu empfangen.

10. Vorrichtung nach einem der Ansprüche 1 bis 4, wobei das jedem Elementarchip (153) zugeordnete Einfang- oder Betätigungselement ein piezoelektrischer Wandler ist.

## Claims

1. Device comprising:
- a transfer substrate (200) comprising electric connection elements; and
- a plurality of elementary chips (153) bonded and electrically connected to the transfer substrate (200), each elementary chip (153) comprising at least one photodetector (D1) and an electronic circuit for reading from said at least one photodetector (D1),
the device further comprising, associated with at least one elementary chip (153), an emission, capture, or actuation element (LR, LG, LB) external to the elementary chip (153), bonded and electrically connected to the transfer substrate (200), **characterized in that** each elementary chip (153) comprises an electronic circuit for controlling the emission, capture, or actuation element (LR, LG, LB) associated with the chip.

2. Device according to claim 1, wherein, in each elementary chip (153), the electronic circuit for reading from said at least one photodetector (D1) and the electronic circuit for controlling the emission, capture, or actuation element (LR, LG, LB) associated with the chip comprise MOS transistors formed inside and on top of a single-crystal silicon layer (103c).

3. Device according to claim 1 or 2, wherein, in each elementary chip (153), said at least one photodetector (D1) is an inorganic photodetector based on a III-V semiconductor material.

4. Device according to claim 3, wherein, in each elementary chip (153), said at least one photodetector (D1) comprises an indium gallium arsenide absorption layer.

5. Device according to any one of claims 1 to 4, wherein the emission, capture, or actuation element comprises at least one light-emitting diode (LR, LG, LB).

6. Device according to claim 5, wherein said at least one light-emitting diode (LR, LG, LB) is an organic light-emitting diode.

7. Device according to claim 5 or 6, wherein each emission, capture, or actuation element comprises three light-emitting diodes (LR, LG, LB) respectively defining three emission sub-pixels, and wherein each elementary chip (153) comprises a plurality of control sub-circuits (R, G, B) adapted to individually controlling respectively the three light-emitting diodes (LR, LG, LB).

8. Device according to claim 7, wherein the three emission sub-pixels are adapted to respectively emitting in three different wavelength ranges.

9. Device according to claim 7 or 8, wherein, in each elementary chip (153), the three control sub-circuits (R, G, B) are coupled to a same input terminal (143) of the chip, connected to a corresponding connection area (P2) of the transfer substrate (200), intended to sequentially receive emission instruction signals (DATA R, DATA G, DATA B) for the three light emitting diodes.

10. Device according to any one of claims 1 to 4, wherein the capture or actuation element associated with each elementary chip (153) is a piezoelectric transducer.
